# EUROPÄISCHE PATENTSCHRIFT

(11) **EP 1 282 344 B1**
(45) Veröffentlichungstag und Bekanntmachung des Hinweises auf die Patenterteilung: **14.01.2009**
(21) Anmeldenummer: 02016343.2
(22) Anmeldetag: 25.07.2002
(51) Int. Cl.: H05K 5/00, H05K 7/14

(54) **Elektronisches Steuergerät in Fahrzeugen**
Electronic controller in vehicle
Appareil de contrôle électronique dans un véhicule

(30) Priorität: 31.07.2001 DE 20112594 U
(43) Veröffentlichungstag der Anmeldung: 05.02.2003
(60) Teilanmeldung: 07011788.2
(73) Patentinhaber: TRW Automotive Electronics & Components GmbH & Co. KG, 78315 Radolfzell (DE)
(72) Erfinder: Skofljanec, Robert, 78345 Moos-Bankholzen (DE)
(74) Vertreter: Prinz & Partner

(56) Entgegenhaltungen:
- DE-A1- 19 911 990
- DE-C1- 19 841 258
- US-A- 5 661 640
- US-B1- 6 243 270

## Beschreibung

Die Erfindung betrifft ein elektronisches Steuergerät für Fahrzeuge gemäß dem Oberbegriff von Anspruch 1.

Die in dem metallischen Gehäuse eines solchen elektronischen Steuergerätes aufgenommenen Elektronikkomponenten dienen beispielsweise zur Steuerung von an das Steuergerät angeschlossenen Insassen-Rückhaltesystemen, wie Gurtstraffer und Airbag.
Für das sichere und zuverlässige Funktionieren des Steuergerätes ist es wichtig, daß die Elektronikkomponenten fest mit dem Gehäusekörper verbunden sind. Zum anderen ist aber auch eine möglichst schnelle und einfache Montage der Elektronikkomponenten sowie ein Gehäusekörper, der für verschiedene Elektronikkomponenten verwendet werden kann, wünschenswert. Bisherige Gehäuse solcher Steuergeräte weisen an ihren Seitenwänden Führungsnuten auf, an denen eine Leiterplatte in das Gehäuse eingeschoben werden kann. Die Leiterplatte wird im eingeschobenen Zustand durch an der Rückseite des Gehäuses ausgebildete Führungselemente zusätzlich gestützt. Durch die seitliche und rückseitige Anbringung der Führungselemente ist es notwendig, daß die Leiterplatte die gesamte Länge und Breite des Gehäuses einnimmt.

Aus der DE-A-199 11 990 ist ein Metallgehäuse für ein Airbag-Steuergerät bekannt, bei dem an den Seitenwänden Führungselemente angeformt sind, in die eine gedruckte Leiterplatte eingeschoben werden kann.

Aus der US-B-6,243,270 ist eine Montageplatte für einen Computer bekannt, die schienenförmige Führungselemente aufweist, und eine Hauptplatine, an deren Unterseite entsprechende Schienen angeschraubt sind. Zum Befestigen der Hauptplatine an einer Montageplatte werden die Schienen in die schienenförmigen Führungselemente geschoben. Im eingeschobenen Zustand wirken elektrische Kontaktierbereiche am Rand der Hauptplatine mit entsprechenden elektrischen Kontakten an einem Sockel zusammen. Durch den Sockel wird außerdem ein Herausgleiten der Hauptplatine aus den schienenförmigen Führungselementen verhindert.

Durch die Erfindung wird ein Steuergerät geschaffen, dessen Elektronikkomponenten zuverlässig und fest mit dem Gehäusekörper verbunden sind und dessen Gehäusekörper zur Aufnahme von Elektronikkomponenten unterschiedlicher Größe verwendet werden kann. Gemäß der Erfindung kann mindestens ein Befestigungselement für eine Elektronikkomponente kann mit dem schienenförmigen Befestigungselement formschlüssig in Eingriff gebracht werden. Durch das Zusammenwirken des schienenförmigen Führungselements mit dem Befestigungselement ist die Elektronikkomponente sicher und fest mit dem Gehäuse verbunden. Es kann deshalb auf ein rückseitiges Führungselement verzichtet werden, so daß beispielsweise das gleiche Gehäuse unabhängig von der Größe der Leiterplatte und der darauf angeordneten Elektronikmodule verwendet werden kann.

Das schienenförmige Führungselement bildet einen innenseitig erweiterten Kanal, in den das Befestigungselement einschiebbar ist. Das Einschieben bietet den Vorteil einer einfachen und schnellen und damit preiswerten Montage der Elektronikkomponenten. Durch ein bereichsweises Deformieren des das Führungselement tragenden Gehäusewand von des Außenseite des Gehäuses her ist das Befestigungselement in dem Kanal blockiertes.

Gemäß einer weiteren bevorzugten Ausführungsform ist ein Gehäuse vorgesehen, an dem außenseitig Kühlrippen angeformt sind. Ein auf einer Leiterplatte angeordneter Leistungshalbleiter ist über das Befestigungselement mit dem Gehäuse wärmeleitend verbunden. Durch die große Kühlfläche des Gehäuses kann so die vom Leistungshalbleiter erzeugte Verlustleistung an die Umgebung abgegeben werden.

Weitere Vorteile und Merkmale ergeben sich aus der folgenden Beschreibung mehrerer Ausführungsformen und aus den Zeichnungen, auf die Bezug genommen wird. In den Zeichnungen zeigen:
- Figur 1 in einer perspektivischen Ansicht ein erfindungsgemäßes Steuergerät mit einem metallischen Gehäuse, an dessen Seitenwänden Montagewinkel befestigt sind;
- Figur 2 in einer schematischen Schnittansicht das erfindungsgemäße Steuergerät von Figur 1;
- Figuren 3a und 3b in einer schematischen Draufsicht zwei unterschiedliche Varianten der Anordnung der Montagewinkel zu einem an einer Seitenwand des Steuergerätes befestigten Steckerkragen;
- Figur 4 in einer perspektivischen Ansicht ein Steuergerät mit montiertem Steckerkragen und Dichtung;
- Figur 5 in einer perspektivischen Ansicht ein erfindungsgemäßes Steuergerät gemäß einer weiteren Ausführungsform, mit einem Steckerkragen, an dessen Innenseite Aufnahmeelemente für Kondensatoren vorgesehen sind;
- Figur 6 in einer perspektivischen Ansicht eine weitere Ausführungsform eines erfindungsgemäßen Steuergerätes, an dessen Gehäuse seitlich Profilschienen befestigt sind;
- Figur 7 in einer perspektivischen Ansicht ein Steuergerät gemäß einer weiteren Ausführungsform mit einem Gehäuse, an dessen Außenseite Kühlrippen angebracht sind;
- Figur 8 in einer schematischen Ansicht eine Leiterplatte mit einem darauf angeordneten Leistungshalbleiter, die über ein in einem schienenförmigen Führungselement angeordnetes Befestigungselement mit Innengewinde mit dem Gehäuse verbunden ist.

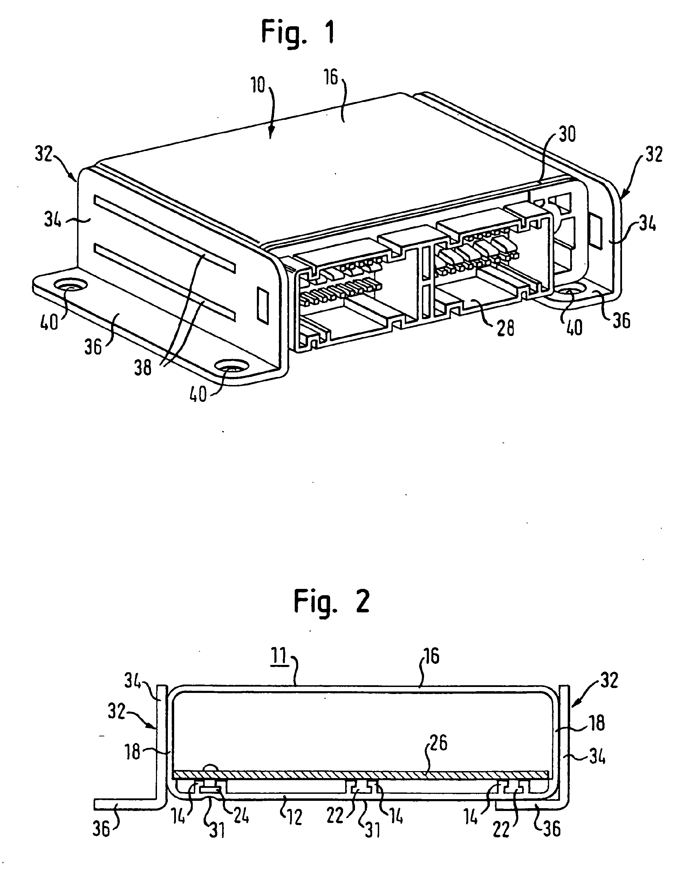

Das in den Figuren 1 und 2 gezeigte Steuergerät weist ein Gehäuse 10 mit einem Gehäusekörper 11 auf, an dessen Bodenwand 12 innenseitig drei parallele, über die gesamte Länge der Bodenwand 12 verlaufende schienenförmige Führungselemente 14 angeformt sind. Der Gehäusekörper 11 weist ferner noch eine Deckwand 16 und zwei Seitenwände 18 auf. Der Gehäusekörper 11 ist bevorzugterweise einstückig durch Fließpressen aus Aluminium hergestellt. Die schienenförmigen Führungselemente 14 bilden jeweils einen innenseitig erweiterten Kanal 22. In dem bezüglich Figur 2 linken Kanal 22 ist ein metallisches Befestigungselement 24 mit seinem bezüglich Figur 2 unteren Ende eingeschoben. Das Befestigungselement 24 ist an seinem bezüglich Figur 2 unteren Ende so geformt, daß es formschlüssig in Eingriff mit dem innenseitig erweiterten Kanal 22 des schienenförmigen Führungselements 14 ist. An seinem bezüglich Figur 2 oberen Ende ist das Befestigungselement 24 an einer Leiterplatte 26 befestigt. Das Befestigungselement 24 kann beispielsweise ein Stift oder Bolzen sein, der an einer in der Leiterplatte 26 ausgebildeten Öffnung verpreßt ist.

Um die Leiterplatte 26 in den Gehäusekörper 11 zu montieren, wird das Befestigungselement 24 zuerst mit seinem bezüglich Figur 2 oberen Ende an der Leiterplatte 26 befestigt. Anschließend wird die Leiterplatte 26, an deren einem Ende ein Steckersockel 28 angebracht ist (siehe auch Figur 1), in den Gehäusekörper 11 eingeschoben, und zwar derart, daß das bezüglich Figur 2 untere Ende des Befestigungselements 24 in Eingriff mit dem innenseitig erweiterten Kanal 22 des schienenförmigen Führungselements 14 gebracht wird und entlang dieses Kanals verschoben wird. Da das Befestigungselement 24 und der Kanal 22 formschlüssig ineinandergreifen, ist die Leiterplatte nur noch längs der Führungsschienen, aber nicht mehr in den beiden dazu senkrechten Richtungen verschiebbar. Die Leiterplatte 26 ist vollständig in das Gehäuse eingeschoben und positioniert, wenn der Steckersockel 28 an einem vorderen Ende 30 des Gehäusekörpers 11 verrastet ist.

Um das Befestigungselement 24 mit der Leiterplatte 26 in dem Kanal 22 vollständig zu blockieren, wird der Gehäusekörper 11 von seiner Außenseite her in dem Bereich 31 der Bodenwand 12, der unterhalb des Befestigungselements 24 gelegen ist, lokal deformiert. Dadurch wird gleichzeitig auch eine elektrisch leitende Verbindung zwischen der Leiterplatte 26 und dem Gehäusekörper 11 über das Befestigungselement 24 hergestellt.

Über das in dem schienenförmigen Führungselement blockierte Befestigungselement ist die Leiterplatte sicher und fest mit dem Gehäusekörper verbunden. Da das Befestigungselement an beliebigen Stellen der Leiterplatte befestigt werden kann, kann das gleiche Gehäuse zur Aufnahme von Leiterplatten unterschiedlicher Größe dienen.

Um das Gehäuse 10 an der Fahrzeugkarosserie zu befestigen, ist an den Seitenwänden 18 des Gehäusekörpers 11 jeweils ein Montagewinkel 32 mit einem ersten Winkelschenkel 34 und einem dazu senkrecht angeordneten zweiten Winkelschenkel 36 vorgesehen. Um die Montagewinkel 32 an den Seitenwänden 18 zu befestigen, sind gemäß der in den Figuren 1 und 2 abgebildeten Ausführungsform an einer Seitenwand 18 des Gehäusekörpers 11 jeweils zwei rippenförmige Vorsprünge 38 angeformt. Diese rippenförmigen Vorsprünge 38 sind jeweils in an dem ersten Winkelschenkel 34 der Montagewinkel 32 gebildeten und zu den rippenförmigen Vorsprüngen komplementären Schlitzen einsetzbar und verpreßbar. Die zweiten Winkelschenkel 36 der Montagewinkel 32 sind jeweils mit Öffnungen 40 versehen, durch die das Gehäuse 10 an der Fahrzeugkarosserie befestigt, beispielsweise verschraubt werden kann.

Die Montagewinkel können wie der bezüglich Figur 1 linke Montagewinkel 32 so zu dem Gehäuse 10 angeordnet werden, daß der zweite Winkelschenkel 36, in dem die Öffnungen 40 gebildet sind, parallel zu der Boden- bzw. Deckwand des Gehäuses verläuft und bezüglich des Gehäuses 10 nach außen hin absteht. Die Montagewinkel können aber auch wie der bezüglich Figur 1 rechte Montagewinkel 32 so angeordnet werden, daß sich der zweite Winkelschenkel 36 wenigstens bereichsweise unterhalb der Bodenwand des Gehäusekörpers 11 befindet. Die Öffnung bzw. die Öffnungen 40 befinden sich dann in dem Bereich des Winkelschenkels 36, der sich nicht unterhalb der Bodenwand 12 des Gehäuses 10 befindet, sondern seitlich übersteht.

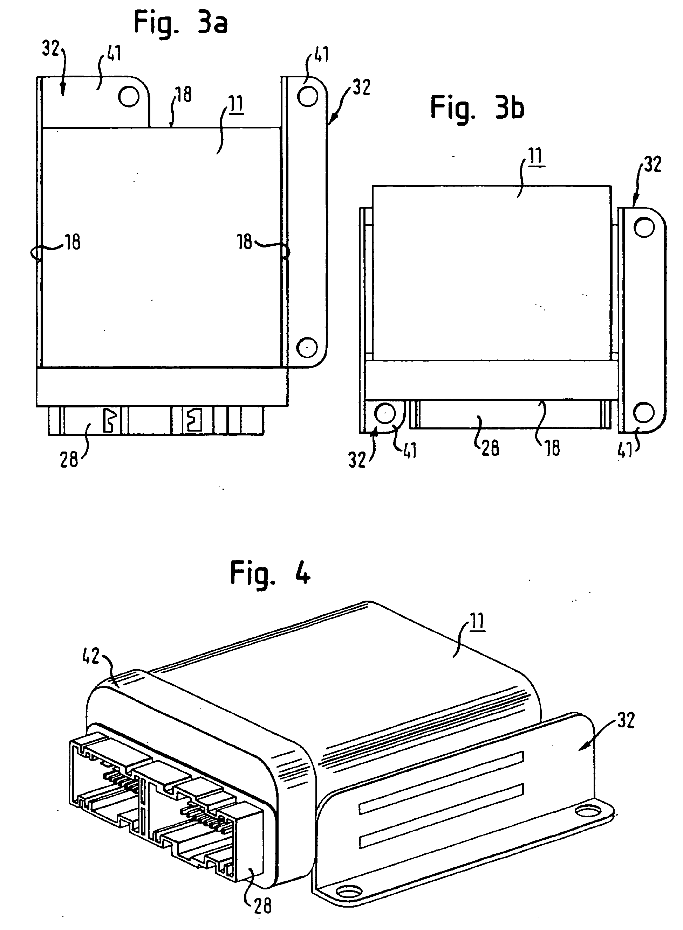

Die Befestigung des Gehäuses 10 an der Fahrzeugkarosserie über die Montagewinkel 32 hat den Vorteil, daß das gleiche Gehäuse in Einbauorte mit unterschiedlich gestalteten Befestigungspunkten eingebaut werden kann, indem man abhängig vom Einbauort Montagewinkel mit unterschiedlich gestalteten Öffnungen 40 an den Seitenwänden des Gehäusekörpers 11 befestigt. Ferner kann durch die Anordnung der Montagewinkel auch die Länge des Steuergerätes variiert werden, wie nun anhand von Figuren 3a und 3b erläutert werden soll:

In Figur 3a ist ein Gehäusekörper 11 mit zwei Montagewinkeln 32 gezeigt, die jeweils eine größere Länge aufweisen als die Seitenwand 18 des Gehäusekörpers 11, an der sie befestigt sind, so daß sie beide mit einem ihrer Enden 41 seitlich überstehen. Der Steckerkragen 28 befindet sich an der den beiden seitlich überstehenden Enden 41 gegenüberliegenden Seitenwand des Gehäusekörpers 11, und er erstreckt sich über fast die gesamte Breite der Seitenwand 18 des Gehäusekörpers 11. Bei dem in Figur 3b dargestellten Steuergerät stehen die Montagewinkel 32 über die Seitenwand 18 des Gehäusekörpers 11 hinaus, an der sich der Steckerkragen 28 befindet. Dadurch kann sich der Steckerkragen 28 nicht, wie bei den in Figur 3a abgebildeten Steuergerät, über im wesentlichen die gesamte Breite der Seitenwand erstrecken, sondern nur über den Bereich der Seitenwand 18, der zwischen den seitlich überstehenden Enden 41 der Montagewinkel 32 gelegen ist. Durch die in Figur 3b abgebildete Anordnung der Montagewinkel 32 zu dem Steckerkragen 28 kann ein Steuergerät geringerer Länge als bei der in Figur 3a abgebildeten Anordnung erhalten werden.

Um eine Abdichtung des Steckerkragens 28 gegenüber dem Gehäusekörper 11 zu erhalten, verfügt der Steckerkragen 28 über eine Dichtung 42, die im montierten Zustand außenseitig an dem Gehäusekörper 11 anliegt (siehe auch Figur 4).

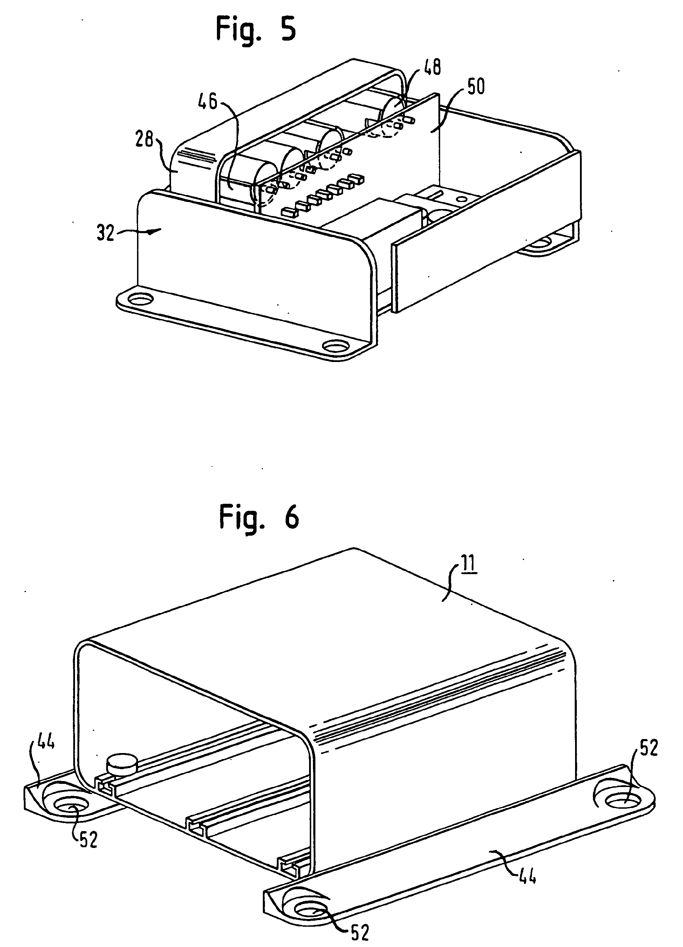

Gemäß einer weiteren, in Figur 5 abgebildeten Ausführungsform ist der innenseitige Bereich des Steckerkragens 28 mit Aufnahmeelementen 46 zur Aufnahme von Kondensatoren 48 ausgebildet. Die Kondensatoren 48 sind an ihrem dem Steckerkragen 28 entgegengesetzten Ende mit einer Leiterplatte 50 elektrisch kontaktiert. Die Anbringung der Kondensatoren 48 in den Aufnahmeelementen 46 im innenseitigen Bereich des Steckerkragens ermöglicht eine einfache Montage der Kondensatoren. Ferner wird dadurch Platz eingespart, so daß kleinere Abmessungen des Gehäusekörpers 11 möglich sind.

Anstatt das Gehäuse 10 durch die Montagewinkel 32 an der Fahrzeugkarosserie zu befestigen, ist gemäß der Erfindung auch, wie in Figur 6 abgebildet, vorgesehen, seitlich am Gehäusekörper 11 Profilschienen 44 mit Öffnungen 52 zu befestigen. Die Profilschienen 44 haben gegenüber den Montagewinkeln 32 den Vorteil, daß sie aus weniger Material gebildet sind und damit kostengünstiger herstellbar sind.

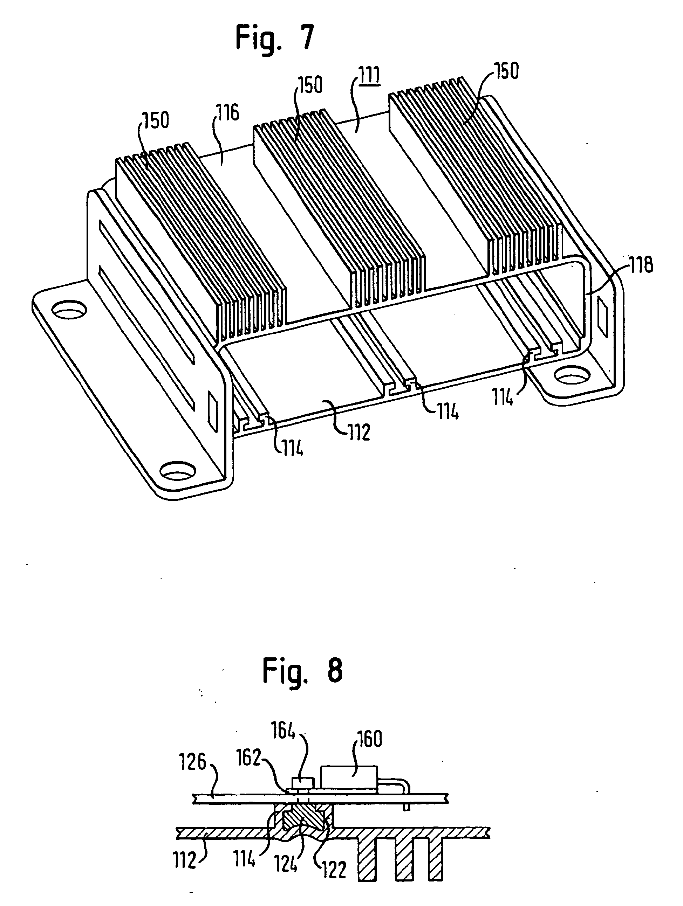

Bei dem in Figur 7 abgebildeten elektronischen Steuergerät sind die der in den Figuren 1 bis 6 gezeigten Ausführungsformen entsprechenden technischen Merkmale durch gleiche Bezugszeichen, nur um 100 erhöht, versehen.
Das in Figur 7 abgebildete Steuergerät unterscheidet sich von dem in den Figuren 1 und 6 abgebildeten Steuergeräten dadurch, daß an der Deckwand 116 des Gehäusekörpers 111 Kühlrippen 150 außenseitig angeformt sind. Die Kühlrippen 150 können wie die schienenförmigen Führungselemente 114 zusammen mit den Seitenwänden 118, der Deckwand 116 und der Bodenwand 112 einstückig durch Fließpressen hergestellt werden. Dieses Gehäuse eignet sich bevorzugterweise zur Aufnahme von Leistungselektronikbauteilen, da durch die große Kühlfläche des Gehäusekörpers die erzeugte Verlustleistung abgeführt werden kann.

Eine erfindungsgemäße Montagemöglichkeit einer Leiterplatte 126 mit einem darauf angeordneten Leistungshalbleiters 160 in dem Gehäusekörper 111 ist in Figur 8 abgebildet. Ein Befestigungselement 124 ist analog der in Figur 2 gezeigten Ausführungsform an seinem einen Ende mit einer Leiterplatte 126 verbunden und an seinem anderen Ende formschlüssig in Eingriff mit dem innenseitig erweiterten Kanal 122 eines schienenförmigen Führungselements 114. Die Bodenwand 112 des Gehäusekörpers 111 ist an der Außenseite des Gehäusekörpers 111 im Bereich des Befestigungselements 124 lokal eingedrückt, um das Befestigungselement 124 in dem Kanal 122 zu blockieren. Das Befestigungselement 124 ist mit einem Innengewinde versehen. Der Leistungshalbleiter 160 weist eine Kühlfahne 162 auf, an der der Leistungshalbleiter über eine in dem Innengewinde des Befestigungselements 124 eingebrachte Schraube 164 mit dem Befestigungselement verbunden ist. Die vom Leistungshalbleiter erzeugte Wärme kann so über die Schraube 164 und das Befestigungselement 124 an den Gehäusekörper 111 und von dort an die Umgebung abgegeben werden.

## Patentansprüche

1. Elektronisches Steuergerät für Fahrzeuge, das ein metallisches Gehäuse (10) zur Aufnahme von Elektronikkomponenten aufweist, wobei an der Innenseite des Gehäuses (10) mindestens ein schienenförmiges Führungselement (14) angeformt ist, **dadurch gekennzeichnet, daß** mindestens ein Befestigungselement (24) für eine Leiter platte (26) formschlüssig in Eingriff mit dem schienenförmigen Führungselement (14) gebracht werden kann, wobei das schienenförmige Führungselement (14) einen innenseitig erweiterten Kanal (22) bildet, in den das Befestigungselement (24) einschiebbar ist, und wobei durch ein bereichsweises Deformieren der das Führungselement (14) tragenden Gehäusewand von der Außenseite des Gehäuses (10) her das Befestigungselement (24) in dem Kanal (22) blockierbar ist.

2. Elektronisches Steuergerät nach Anspruch 1, **dadurch gekennzeichnet, daß** eine Leiterplatte (26) vorgesehen ist, die in das Gehäuse (10) einschiebbar ist, und daß das Befestigungselement (24) an der Leiterplatte (26) befestigt ist.

3. Elektronisches Steuergerät nach Anspruch 2, **dadurch gekennzeichnet, daß** die Leiterplatte (26) durch das Befestigungselement (24) mit dem Gehäuse (10) elektrisch leitend verbunden ist.

4. Elektronisches Steuergerät nach einem der vorhergehenden Ansprüche, **dadurch gekennzeichnet, daß** das Führungselement (14) an einer Bodenwand (12) des Gehäuses (10) angeordnet ist.

5. Elektronisches Steuergerät nach Anspruch 4, **dadurch gekennzeichnet, daß** das schienenförmige Führungselement (14) über die gesamte Länge oder Breite der Bodenwand (12) verläuft.

6. Elektronisches Steuergerät nach Anspruch 4 oder 5, **dadurch gekennzeichnet, daß** mindestens zwei parallele schienenförmige Führungselemente (14) an der Bodenwand (12) angeordnet sind.

7. Elektronisches Steuergerät nach einem der vorhergehenden Ansprüche, **dadurch gekennzeichnet, daß** an Seitenwänden (18) des Gehäuses (10) jeweils mindestens ein Vorsprung (38) angeformt ist und daß jeweils ein Montagewinkel (32) mit einer zu dem Vorsprung (38) komplementären Ausnehmung versehen ist, in die der Vorsprung (38) der Seitenwand (18) einsetzbar und verpreßbar ist.

8. Elektronisches Steuergerät nach Anspruch 7, **dadurch gekennzeichnet, daß** der Vorsprung eine Rippe (38) und die komplementäre Ausnehmung ein Schlitz ist.

9. Elektronisches Steuergerät nach einem der Ansprüche 7 oder 8, **dadurch gekennzeichnet, daß** wenigstens einer der Montagewinkel (32) einen Winkelschenkel (36) aufweist, der unter die Bodenwand (12) des Gehäuses (10) greift und seitlich über diesen hinausragt.

10. Elektronisches Steuergerät nach einem der vorhergehenden Ansprüche, **dadurch gekennzeichnet, daß** das Gehäuse (10) einen durch Fließpressen hergestellten Gehäusekörper (11) aufweist, der aus Deckwand (16), Bodenwand (12) und Seitenwänden (18) besteht und an dem wenigstens ein schienenförmiges Führungselement (14) innenseitig angeformt ist.

11. Elektronisches Steuergerät nach einem der vorhergehenden Ansprüche, **dadurch gekennzeichnet, daß** das Gehäuse (110) einen durch Fließpressen hergestellten Gehäusekörper (111) aufweist, der aus Deckwand (116), Bodenwand (112) und Seitenwänden (118) besteht und an Kühlrippen (150) außenseitig angeformt sind.

## Claims

1. An electronic control device for a vehicle, comprising a metallic housing (10) for the accommodation of electronic components, at least one rail-shaped guide element (14) being formed integrally with the inside of the housing (10), **characterized in that** at least one fastening element (24) for a printed circuit board (26) can be engaged in a form-fitting manner with the rail-shaped guide element (14), the rail-shaped guide element (14) defining an internally widened channel (22) into which the fastening element (24) can be inserted, and the fastening element (24) being adapted to be blocked in the channel (22) by deforming portions of the housing wall that supports the guide element (14) from the outside of the housing (10).

2. The electronic control device according to claim 1, **characterized in that** a printed circuit board (26) is provided which can be inserted into the housing (10), and that the fastening element (24) is attached to the printed circuit board (26).

3. The electronic control device according to claim 2, **characterized in that** the printed circuit board (26) is electrically conductively connected to the housing (10) by the fastening element (24).

4. The electronic control device according to any of the preceding claims, **characterized in that** the guide element (14) is arranged on a bottom wall (12) of the housing (10).

5. The electronic control device according to claim 4, **characterized in that** the rail-shaped guide element (14) extends across the entire length or width of the bottom wall (12).

6. The electronic control device according to claim 4 or 5, **characterized in that** at least two parallel rail-shaped guide elements (14) are arranged on the bottom wall (12).

7. The electronic control device according to any of the preceding claims, **characterized in that** side walls (18) of the housing (10) each have at least one projection (38) formed integrally therewith, and that one mounting bracket (32) each is provided having a recess that is complementary to the projection (38) and into which the projection (38) of the side wall (18) can be inserted and press-fitted.

8. The electronic control device according to claim 7, **characterized in that** the projection is a rib (38) and the complementary recess is a slit.

9. The electronic control device according to one of claims 7 or 8, **characterized in that** at least one of the mounting brackets (32) has a bracket leg (36) that engages under the bottom wall (12) of the housing (10) and projects laterally beyond it.

10. The electronic control device according to any of the preceding claims, **characterized in that** the housing (10) has a housing body (11) which is made by impact extrusion and consists of a top wall (16), a bottom wall (12) and side walls (18) and which has at least one rail-shaped guide element (14) formed integrally therewith on the inside.

11. The electronic control device according to any of the preceding claims, **characterized in that** the housing (110) has a housing body (111) which is made by impact extrusion and consists of a top wall (116), a bottom wall (112) and side walls (118), cooling ribs (150) being formed integrally therewith on the outside.

## Revendications

1. Appareil de commande électronique dans des véhicules, comportant un boîtier (10) métallique servant à recevoir des composants électroniques, au moins un élément de guidage (14) en forme de glissière étant façonné sur la face intérieure du boîtier (10), **caractérisé en ce qu'**au moins un élément de fixation (24) pour une carte de circuit imprimé (26) peut être mis en engagement par coopération de formes avec l'élément de guidage (14) en forme de glissière, l'élément de guidage (14) en forme de glissière formant un canal (22) évasé sur la face 'intérieure, dans lequel l'élément de fixation (24) peut être inséré, et l'élément de fixation (24) pouvant être bloqué dans le canal (22) par une déformation de portions de la paroi de boîtier portant l'élément de guidage (14), depuis l'extérieur du boîtier (10).

2. Appareil de commande électronique selon la revendication 1, **caractérisé en ce qu'**il est prévu une carte de circuit imprimé (26) qui peut être insérée dans le boîtier (10), et **en ce que** l'élément de fixation (24) est fixé sur la carte de circuit imprimé (26).

3. Appareil de commande électronique selon la revendication 2, **caractérisé en ce que** la carte de circuit imprimé (26) est reliée de manière électroconductrice au boîtier (10) par l'élément de fixation (24).

4. Appareil de commande électronique selon l'une des revendications précédentes, **caractérisé en ce que** l'élément de guidage (14) est agencé sur une paroi de fond (12) du boîtier (10).

5. Appareil de commande électronique selon la revendication 4, **caractérisé en ce que** l'élément de guidage (14) en forme de glissière s'étend sur toute la longueur ou sur toute la largeur de la paroi de fond (12).

6. Appareil de commande électronique selon la revendication 4 ou 5, **caractérisé en ce qu'**au moins deux éléments de guidage (14) parallèles en forme de glissières sont agencés sur la paroi de fond (12).

7. Appareil de commande électronique selon l'une des revendications précédentes, **caractérisé en ce que** sur des parois latérales (18) du boîtier (10) est façonnée au moins une saillie (38) respective et **en ce qu'**une cornière de montage (32) respective est pourvue d'un évidement complémentaire à la saillie (38), dans lequel la saillie (38) de la paroi latérale (18) peut être insérée et pressée.

8. Appareil de commande électronique selon la revendication 7, **caractérisé en ce que** la saillie est une nervure (38) et l'évidement complémentaire est une fente.

9. Appareil de commande électronique selon l'une des revendications 7 ou 8, **caractérisé en ce qu'**au moins une des cornières de montage (32) présente une jambe de cornière (36) qui s'engage au-dessous de la paroi de fond (12) du boîtier (10) et fait saillie latéralement au-delà de celui-ci.

10. Appareil de commande électronique selon l'une des revendications précédentes, **caractérisé en ce que** le boîtier (10) présente un corps de boîtier (11) fabriqué par extrusion qui est constitué par une paroi de recouvrement (16), une paroi de fond (12) et des parois latérales (18) et sur lequel au moins un élément de guidage (14) en forme de glissière est façonné sur la face intérieure.

11. Appareil de commande électronique selon l'une des revendications précédentes, **caractérisé en ce que** le boîtier (110) présente un corps de boîtier (111) fabriqué par extrusion qui est constitué par une paroi de recouvrement (116), une paroi de fond (112) et des parois latérales (118) et **en ce que** des nervures de refroidissement (150) sont façonnées sur la face extérieure.
